# EUROPEAN PATENT SPECIFICATION

(11) **EP 1 485 996 B1**
(45) Date of publication and mention of the grant of the patent: **08.05.2019**
(21) Application number: 03716400.1
(22) Date of filing: 10.03.2003
(51) Int. Cl.: H03F 3/26, H03F 3/72, H03F 3/42, H03F 3/60

(54) **RECONFIGURABLE DISTRIBUTED ACTIVE TRANSFORMERS**
REKONFIGURIERBARER AKTIVER VERTEILTER TRANSFORMATOR
TRANSFORMATEURS ACTIFS REPARTIS RECONFIGURABLES

(30) Priority: 11.03.2002 US 363424 P
(43) Date of publication of application: 15.12.2004
(73) Proprietor: CALIFORNIA INSTITUTE OF TECHNOLOGY, Pasadena, California 91125 (US)
(72) Inventor: KOMIJANI, Abbas, Los Angeles, CA 90066 (US); HAJIMIRI, Seyed-Ali, Pasadena, CA 91107 (US); KEE, Scott, D., Tustin, CA 92782 (US); AOKI, Ichiro, Arcadia, CA 91007 (US)
(74) Representative: Lloyd, Patrick Alexander Desmond
(86) International application number: PCT/US2003/007157
(87) International publication number: WO 2003/079547

(56) References cited:
- EP-A- 0 379 202
- WO-A-01/56171
- US-A- 5 793 253
- US-A- 5 930 128
- AOKI I ET AL: "DISTRIBUTED ACTIVE TRANSFORMER-A NEW POWER-COMBINING AND IMPEDANCE-TRANSFORMATION TECHNIQUE" IEEE TRANSACTIONS ON MICROWAVE THEORY AND TECHNIQUES, IEEE INC. NEW YORK, US, vol. 50, no. 1, PART 2, January 2002 (2002-01), pages 316-331, XP001085553 ISSN: 0018-9480

## Description

### FIELD OF THE INVENTION

The present invention pertains to the field of distributed active transformers and corresponding methods. More specifically, the invention relates to distributed active transformers that include features that provide additional control over operational parameters.

### BACKGROUND OF THE INVENTION

A distributed active transformer includes a primary winding that uses active devices to control the current direction and magnitude on the winding. For example, U. S. patent application 09/974, 578, filed October 9,2001, describes distributed active transformers that can comprise at least two push/pull amplifiers designed to amplify an RF input signal. The distributed active transformer can be operated where a first amplifier causes current to flow on the primary winding in a first direction, and where a second amplifier causes current to flow on the primary winding in a second direction. In this manner, an alternating current is induced on the secondary winding.

The paper by Aoki Ichiro, entitled "Distributed Active Transformer - A new Power Combining and Impedance Transformation Technique" discusses the operation of a distributed active transformer.

An arrangement of primary and secondary windings in a waveform synthesiser is known from patent US 5,930,128.

### SUMMARY OF THE INVENTION

The invention is defined in the independent claims to which reference should be made. Advantageous features are set forth in the dependent claims.

In particular, a distributed active transformer is provided that allows sections of the distributed active transformer to be independently controlled.

In accordance with an exemplary embodiment of the present invention, a distributed active transformer is provided. The distributed active transformer includes a primary winding having two or more sets of push/pull amplifiers, where each set of push/pull amplifiers is used to create an alternating current on a section of the primary winding. A secondary winding is disposed adjacent to the primary winding, such that the alternating current on the primary induces alternating current on the secondary. The primary winding and the secondary winding can be disposed on a semiconductor substrate.

The present invention provides many important technical advantages. One important technical advantage of the present invention is a distributed active transformer that allows sections of the distributed active transformer to be independently controlled, so as to adjust the operating parameters of the distributed active transformer.

Those skilled in the art will appreciate the advantages and superior features of the invention together with other important aspects thereof on reading the detailed description that follows in conjunction with the drawings.

### BRIEF DESCRIPTION OF THE SEVERAL VIEWS OF THE DRAWINGS

FIGURE 1 is a diagram of a distributed active transformer in accordance with an exemplary embodiment of the present invention;
FIGURE 2 is a diagram of a distributed active transformer with two primary windings in accordance with an example;
FIGURES 3 and 3A are diagrams of a distributed active transformer with first and second primary windings and compensating capacitors in accordance with an example;
FIGURE 4 is a diagram of a distributed active transformer with first and second primary windings and compensating capacitors in accordance with another example;
FIGURE 5 is a diagram of a distributed active transformer with impedance transformation ratio correction and resonance frequency selection in accordance with an exemplary embodiment of the present invention;
FIGURE 6 is a diagram of a distributed active transformer with switched-in capacitors that are in parallel with amplifiers in accordance with an exemplary embodiment of the present invention;
FIGURE 7 is a diagram of a distributed active transformer with a low noise amplifier in accordance with an example; and
FIGURE 8 is a diagram of a distributed active transformer with a low noise amplifier in accordance with another example.

### DETAILED DESCRIPTION OF THE INVENTION

In the description that follows like parts are marked throughout the specification and drawings with the same reference numerals, respectively. The drawing figures are not necessarily to scale and certain features may be shown in somewhat generalized or schematic form in the interest of clarity and conciseness.

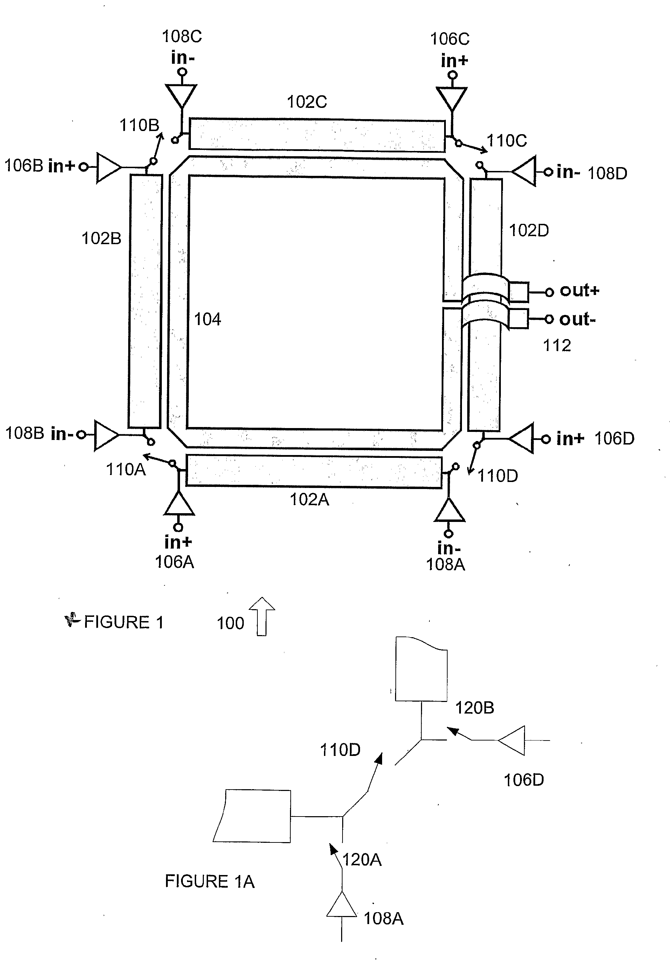

**FIGURES 1** **AND 1A** are diagrams of distributed active transformer 100 in accordance with an exemplary embodiment of the present invention. Distributed active transformer 100 allows the number of primary sections in the primary winding of a distributed active transformer to be reconfigured.

Distributed active transformer 100 includes primary winding sections 102A, 102B, 102C, and 102D, and secondary winding 104. Each primary winding section has an associated push/pull amplifier pair that includes amplifiers 106A and 108A for primary winding section 102A, amplifiers 106B and 108B for primary winding section 102B, amplifiers 106C and 108C for primary winding section 102C, and amplifiers 106D and 108D for primary winding section 102D. The amplifiers can be implemented using bipolar junction transistors (BJTs), metal oxide semiconductor field-effect transistors (MOSFETs), hetero-junction bipolar transistors (HBTs), metal-semiconductor field effect transistors (MESFETs), lateral double-diffused metal oxide semiconductor transistors (LDMOSs), complementary MOS transistors (CMOS), or other suitable devices. Amplifier 106A drives current to the positive terminal of primary winding section 102A, whereas amplifier 108A drives current from the negative terminal of primary winding section 102A. The polarities of the amplifiers can be alternated to reverse the direction of current flow. A drain voltage V_{dd} (not explicitly shown) may alternatively be provided at a midway point, corner, or at other suitable locations on each primary winding section to provide the current source or other suitable configurations can be used to create time-varying current on the primary winding sections using the push/pull amplifier pairs. A similar configuration is used for primary winding sections 102B, 102C, and 102D.

Each push/pull amplifier pair of each primary winding section can be controlled so that the current flowing on the primary winding section alternates in direction and magnitude in a manner that creates a magnetic field that induces an electromotive force (EMF) on secondary winding 104. The EMF causes current to flow in secondary winding 104, based on the impedance of that winding and any associated circuit. The current through the push/pull amplifier pairs can be controlled so as to adjust both the current and the voltage induced in this manner on secondary winding 104.

Switches 110A, 110B, 110C, and 110D can be implemented as transistors, micro-electromechanical devices (MEMS), or other suitable devices, and are connected to a one amplifier out of each set of two adjacent push/pull amplifier pairs, such that the two adjacent push/pull amplifiers can be bypassed and a new push/pull amplifier pair can be created. As used herein, "connect" and its cognate terms such as "connects" or "connected" can refer to a connection through a conductor, a semiconducting material, or other suitable connections. In one exemplary embodiment, amplifiers 106A and 108B are connected to switch 110A, such that the amplifiers can be bypassed by closing switch 110A. In this embodiment, amplifiers 106B and 108A would then form the push/pull amplifier pair for primary winding sections 102A and 102B. Likewise, a similar configuration can be provided for switches 110B, 110C and 110D. In this regard, it should be noted that the set of push/pull amplifiers that the switches are connected to is different from the set of push/pull amplifiers that service each primary winding section. Nevertheless, each switch can operate to bypass one amplifier from a first push/pull amplifier pair and a second amplifier from a second push/pull amplifier pair so as to result in the remaining amplifiers from those two push/pull amplifier pairs operating as a push/pull amplifier pair on a combined primary winding section.

For example, if switch 110A is closed, the power level generated by distributed active transformer 100 is less than the power level that is generated for distributed active transformer 100 with all switches open. The current magnitude through secondary winding 104 will be determined by the sum of the electromotive forces induced on the secondary by each primary winding section, which equals the change in flux linkages over time (dΦ/dt) which is determined by the mutual inductance of the primary and the secondary and the change in the current of the secondary (M * dI/dt.)

When a push-pull configuration is used with no V_{dd} points, closing a single switch 110 results in an increased impedance for each remaining push/pull amplifier pair that drives current through the two connected primary winding sections. This configuration decreases the output power by increasing the impedance seen by the remaining amplifiers. Alternately, the winding sections can be capacitively coupled, such that the impedance seen by each amplifier remains the same, but where power is controlled by turning off or switching out amplifier sections. In either configuration, turning off amplifiers results in a decrease in output power and can be used to lower the overall power dissipation of the amplifier.

When a push-pull configuration is used that includes V_{dd} points, with a single switch 110 closed, one quarter of the primary winding section will not be carrying any current, as no current will flow between the V_{dd} points of the two connected primary winding sections.

In the described configurations, closing one switch can decrease the flux linkages between the primary and secondary windings, such that the open loop voltage on the secondary will be decreased to fraction of the maximum open loop voltage that could be realized with all switches 110A through 110D open. Likewise, with two and three switches 110 closed, the open loop voltage will drop more. Thus, distributed active transformer 100 can operate in four different modes of operation - a maximum power mode with all switches 110A through 110D open, a medium-high power mode, with any one of switches 110A through 110D closed, a medium-low power mode with any two of switches 110A through 110D closed, and a low power mode with any three of switches 110A through 110D closed. The power levels will be a function of whether the impedance seen by each amplifier is constant or varies as a function of the switches that are closed, as well as other factors.

In addition to providing different power modes of operation with switches 110A through 110D, the biasing current required for each of the bypassed amplifiers can also be decreased, such that the bias current requirements for distributed active transformer 100 can also be controlled. For example, with all switches 110A through 110D open, the bias current required for each of amplifiers 106A and 108A through 106D and 108D can be at a maximum. If switch 110A is closed, then the bias current required for amplifiers 106A and 108B can decrease. In this manner, bias current requirements for distributed active transformer 100 can be controlled through the use of switches 110A through 110D, where suitable. Likewise, the bias current for a given power level can be optimized by determining the power level range for a given switch setting, and using the range that provides the lowest bias current for the expected range of operation. For example, if the expected power levels for the operating range of an application would fall within either the power level range for operation of distributed active transformer 100 with either two of switches 110 closed or three of switches 110 closed, then operation of distributed active transformer 100 with three of switches 110 closed would satisfy the power requirements for the operating range while minimizing the bias current required to support operation.

**FIGURE 1A** shows an exemplary configuration of switches 120A and 120B, which can be used to connect or disconnect amplifiers 108A and 106D, respectively, from distributed active transformer 100 while allowing 102A and 102D to be independently coupled or decoupled. The exemplary configuration of switches 120A and 120B can be implemented at each connection between each primary winding section, secondary winding sections (if such sections are used), or in other suitable locations. Switches 120A and 120B thus provide additional flexibility for the configuration of distributed active transformer 100.

In operation, distributed active transformer 100 allows the power capability and biasing current requirements to be controlled through the operation of switches 110A through 110D. In this manner, additional control of the power output and power consumption of a distributed active transformer is provided.

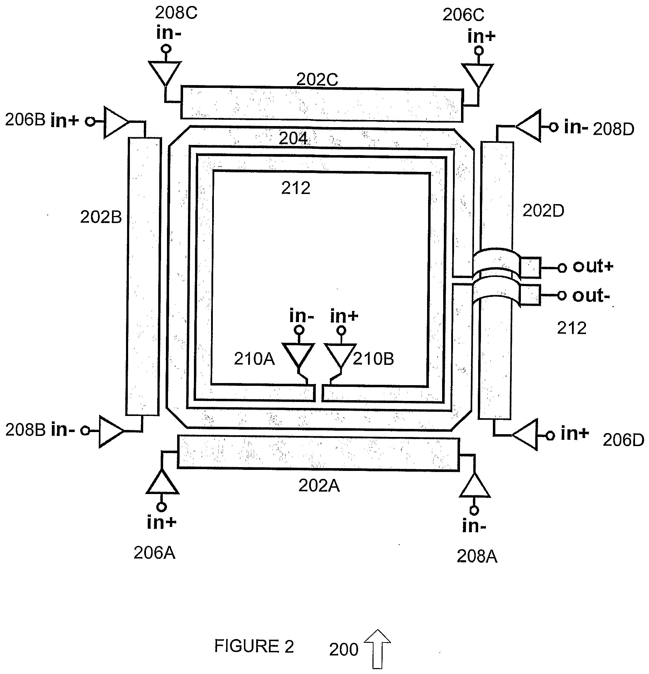

**FIGURE 2** is a diagram of distributed active transformer 200 with two primary windings in accordance with an example. Additional primary and secondary windings can likewise be provided for additional power conversion control, either internal or external to the secondary winding.

Distributed active transformer 200 includes first primary winding sections 202A, 202B, 202C, and 202D, and second primary winding 212. Secondary winding 204 is disposed between the first primary winding sections 202A through 202D and second primary winding 212. For the first primary winding sections, push/pull amplifiers 206A and 208A are associated with primary winding section 202A, push/pull amplifiers 206B and 208B are associated with primary winding section 202B, push/pull amplifiers 206C and 208C are associated with primary winding section 202C, and push/pull amplifiers 206D and 208D are associated with primary winding section 202D. Likewise, push/pull amplifiers 210A and 210B are associated with second primary winding 212, although a single driver amplifier can alternatively be used where suitable. The secondary winding has an output 214.

Distributed active transformer 200 can operate with primary winding sections 102A through 102D active and second primary winding 212 inactive. In this mode, distributed active transformer 200 can provide higher power but with increased bias current requirements. Likewise, distributed active transformer 200 can operate with primary winding sections 102A through 102D inactive and with second primary winding 212 active. In this exemplary embodiment, the power delivered to output 214 can be lower than the power delivered to output 214 when first primary winding sections 202A through 202D are activated, but the bias current required can be lower than the bias required with primary winding sections 202A through 202D active.

In another example, the spacing between second primary winding 212 and secondary winding 204 can be increased, so as to decrease the magnetic coupling between the primary and secondary windings. The power loss in second primary winding 212 when it is not being used can thus be decreased, as well as the voltage breakdown requirements of push/pull amplifiers 210A and 210B. Additional primary windings can likewise be provided, depending on the power levels required and the available space.

In operation, distributed active transformer 200 can be operated in a first mode for high power with high bias current requirements by activation of primary winding sections 202A through 202D, and in a second mode with lower power and bias current requirements by activation of second primary winding 212. Use of a first primary winding and a second primary winding allows the power output and bias current requirements for a distributed active transformer to be adjusted as needed by switching between primaries.

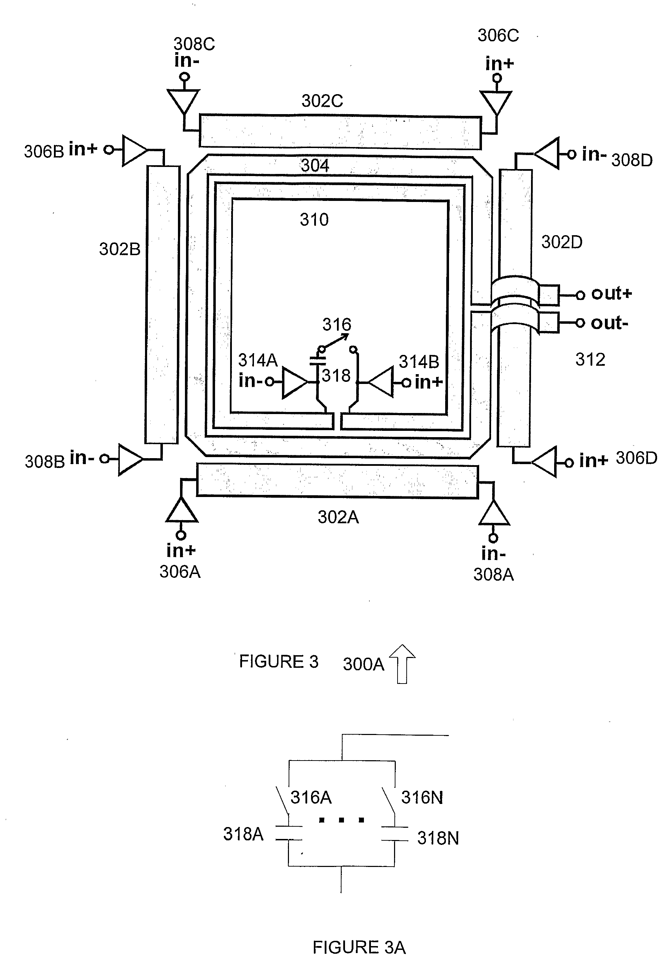

**FIGURES 3** **AND 3A** are diagrams of distributed active transformer 300A with first and second primary windings and compensating capacitors in accordance with an example.

Distributed active transformer 300A allows the power loss caused by circulating currents in an unused primary winding to be mitigated through the use of a switched series capacitance, as well as decreasing the breakdown voltage imposed on the associated primary winding amplifiers.

Distributed active transformer 300A includes primary winding sections 302A through 302D with associated push/pull amplifier pairs 306A and 308A through 306D and 308D, respectively, and secondary winding 304 with output 312. Likewise, second primary winding 310 includes push/pull amplifiers 314A and 314B, which can be connected using switch 316 through capacitor 318. When capacitor 318 is connected in parallel with second primary winding 310 through switch 316, an LC resonant circuit can be formed with secondary winding 304. When second primary winding 310 is not in use, switch 316 can be opened to take second primary winding 310 out of resonance with secondary winding 304 and decrease losses due to circulating currents, as well as to decrease the peak voltage imposed on push/pull amplifiers 314A and 314B when they are inactive. In general, capacitors can be switched into and out of windings in other suitable configurations, to take the windings in and out of resonance with other windings.

As shown in **FIGURE 3A**, a suitable configuration of switches and capacitors can be used in lieu of a single switch 316 and capacitor 318, where each switch-capacitor pair can be controlled separately, thus allowing the resonance frequency of the secondary loop to be adjusted. In one exemplary embodiment, this combination can be used to adjust the center frequency of a power amplifier so as to achieve a flat gain and efficiency response across multiple frequency bands or channels, to account for manufacturing process variations, to account for temperature variations, or for other suitable purposes.

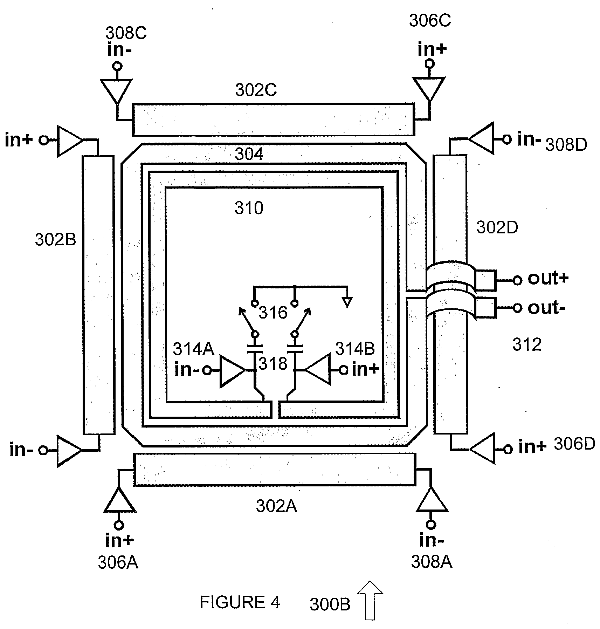

**FIGURE 4** is a diagram of distributed active transformer 300B with first and second primary windings and compensating capacitors in accordance with an example. Distributed active transformer 300B allows the power loss caused by circulating currents in an unused primary winding to be mitigated through the use of switched capacitors, as well as decreasing the breakdown voltage imposed on the associated primary winding amplifiers.

Distributed active transformer 300B includes primary winding sections 302A through 302D with associated push/pull amplifier pairs 306A and 308A through 306D and 308D, respectively, with secondary winding 304 and output 312. Likewise, second primary winding 310 includes push/pull amplifiers 314A and 314B, which can be connected using switches 316 through capacitors 318. When capacitors 318 are connected to second primary winding 310 through switches 316, an LC resonant circuit is created with secondary winding 304. When second primary winding 310 is not in use, switches 316 can be opened to take second primary winding 310 out of resonance with secondary winding 304 and decrease losses due to circulating currents, as well as to decrease the peak voltage imposed on push/pull amplifiers 314A and 314B when they are inactive.

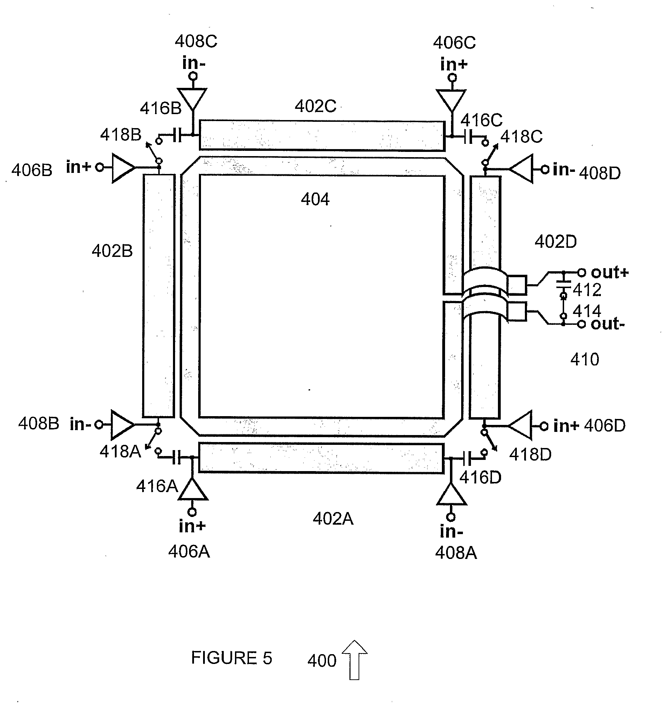

**FIGURE 5** is a diagram of distributed active transformer 400 with impedance transformation ratio correction and resonance frequency selection in accordance with an exemplary embodiment of the present invention. Distributed active transformer 400 includes primary winding sections 402A through 402D with associated push/pull amplifiers 406A and 408A through 406D and 408D, respectively. Switches 418A through 418D are connected in series with capacitors 416A through 416D, respectively. Output 410 of secondary winding 404 includes switch 414 and capacitor 412 for impedance transformation ratio control. Alternatively, switch 414 and capacitor 412 can be omitted, such as where it is desirable only to allow the resonance frequency of distributed active transformer 400 to be controlled. Likewise, a suitable configuration of switches and capacitors can be used in lieu of a single switch 414 and capacitor 412, where each switch-capacitor pair can be controlled separately, thus allowing the resonance frequency of the secondary loop to be adjusted.

In this exemplary embodiment, the power operation mode of distributed active transformer 400 can be controlled, such as by closing one or more of switches 418A through 418D, so as to insert capacitors 416A through 416D in series with primary winding sections 402A through 402D. In this manner, a series LC circuit is created to compensate for leakage inductance between the primary winding sections 402A through 402D and secondary winding 404. Thus, by placing one or more of capacitors 416A through 416D in series with primary winding sections 402A though 402D, the maximum output power is decreased, but the bias current required to achieve a gain level is also decreased. Alternatively, if capacitor 412 is placed in parallel across the load by closing switch 414 to compensate for this leakage inductance, then the impedance transformation ratio is increased, which increases the maximum output power but which also increases the bias current requirements.

In addition, the resonant frequency of distributed active transformer 400 can be adjusted for a particular frequency of operation by switching in capacitors 416A through 416D. In this manner, the efficiency and power output by distributed active transformer 400 can be optimized for a desired frequency of operation by configuring it for resonance at that frequency. Thus, depending on the sizes of the capacitors, distributed active transformer 400 can be operated in a first mode either with or without switch 414 and capacitor 412 to change the impedance transformation ratio by compensating for winding leakage inductance, in a second mode without switch 414 and capacitor 412 to change the resonant frequency of distributed active transformer 400, or in both modes simultaneously. Likewise, a suitable configuration of switches and capacitors can be used in lieu of switches 418 and capacitors 416, where each switch-capacitor pair can be controlled separately, thus allowing the resonance frequency of the primary loop to be adjusted.

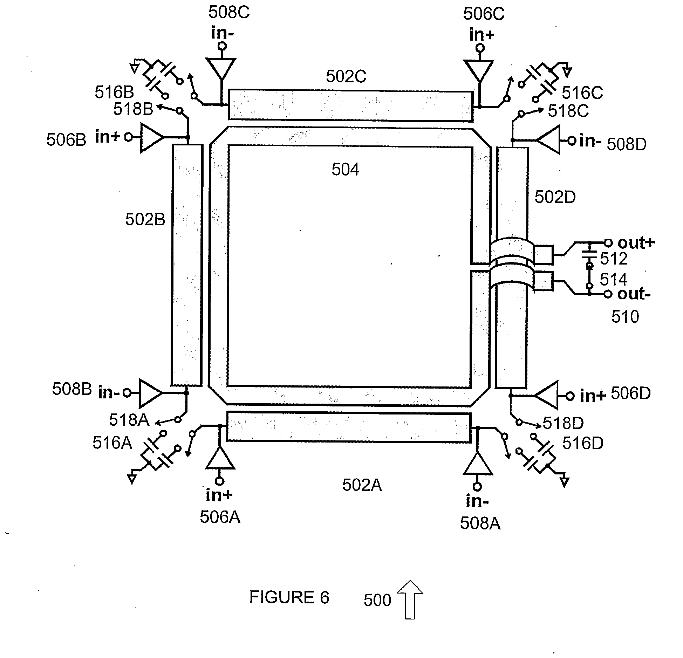

**FIGURE 6** is a diagram of distributed active transformer 500 with switched-in capacitors that are in parallel with amplifiers 506A and 508A through 506D and 508D, in accordance with an exemplary embodiment of the present invention. Distributed active transformer 500 includes primary windings sections 502A through 502D with associated push/pull amplifiers 506A and 508A through 506D and 508D, respectively. Switch pairs 518A through 518D are connected in series with capacitor pairs 516A through 516D, respectively. Output 510 of secondary winding 504 includes switch 514 and capacitor 512 for impedance transformation ratio control. Alternatively, switch 514 and capacitor 512 can be omitted, such as where it is desirable to allow the resonance frequency of distributed active transformer 500 to be controlled.

In this exemplary embodiment, the power operation mode of distributed active transformer 500 can be controlled, such as by closing one or more of switch pairs 518A through 518D, so as to insert capacitor pairs 516A through 516D in series with primary winding sections 502A through 502D. In this manner, a series LC circuit is provided to compensate for leakage inductance between the primary winding sections 502A through 502D and secondary winding 504. Thus, by placing one or more of capacitor pairs 516A through 516D in series with primary winding sections 502A though 502D, the maximum output power is decreased, but the bias current required to achieve a gain level is also reduced. Alternatively, if capacitor 512 is placed in parallel across the load by closing switch 514 to compensate for this leakage inductance, then the impedance transformation ratio is increased, which increases the maximum output power but which also increases the bias current requirements.

In addition, the resonant frequency of distributed active transformer 500 can be adjusted for a particular frequency of operation by switching in capacitor pairs 516A through 516D. In this manner, the efficiency and power output of distributed active transformer 500 can be optimized for a desired frequency of operation by placing it in resonance for that frequency. Thus, depending on the sizes of the capacitors, distributed active transformer 500 can be operated in a first mode either with or without switch 514 and capacitor 512 to change the impedance transformation ratio by compensating for winding leakage inductance, in a second mode without switch 514 and capacitor 512 to change the resonant frequency of distributed active transformer 500, or in both modes simultaneously.

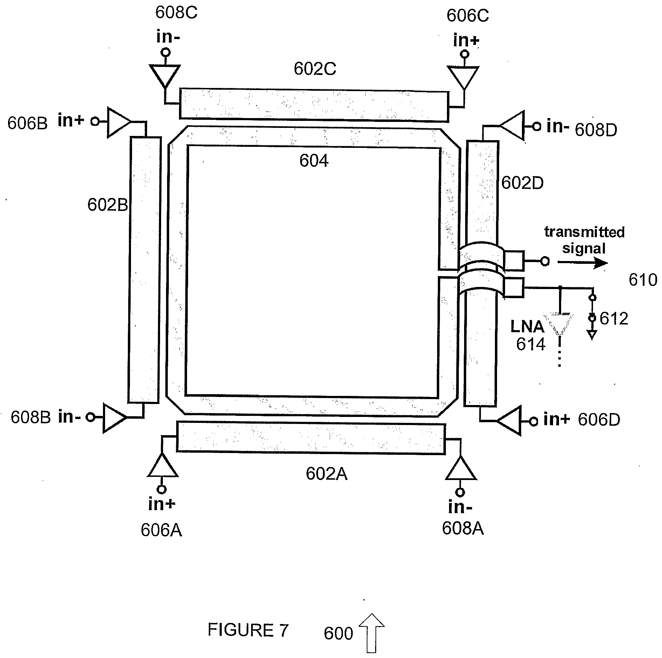

**FIGURE 7** is a diagram of distributed active transformer 600 integrated with a low noise amplifier in accordance with an example.

In addition to the primary and secondary windings and associated push/pull amplifiers previously described, distributed active transformer 600 includes a low noise amplifier 614 and associated switch 612. When switch 612 is closed, as shown, a transmitted signal can be provided by modulating the input through push/pull amplifiers 606A and 608A through 606D and 608D. When switch 612 is opened and push/pull amplifier pairs 606A and 608A through 606D and 608D are not operated, a received signal can be fed through an inductor coil formed by the secondary winding of distributed active transformer 600, and low noise amplifier 614 can be used to process the signal. In this manner, integration of low noise amplifier 614 with switch 612 through a single-ended output of distributed active transformer 600 allows a receiver/transmitter architecture to be implemented. In one exemplary embodiment, distributed active transformer 600 can be used in place of a transmit switch in a transceiver, or for other suitable applications.

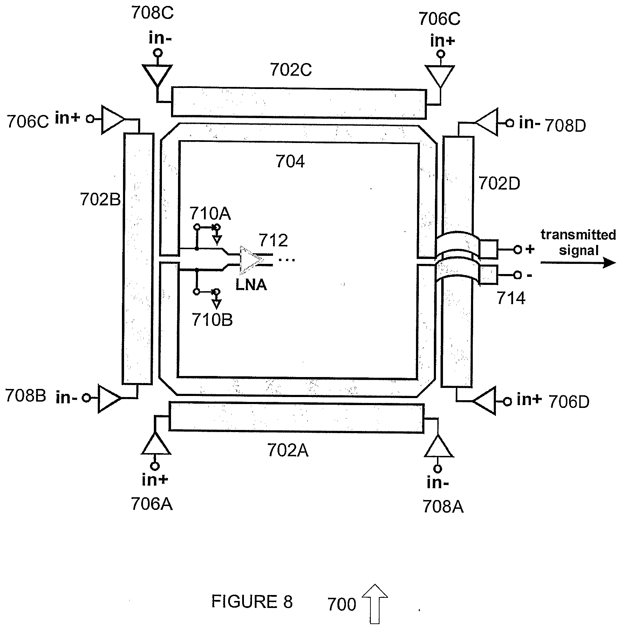

**FIGURE 8** is a diagram of distributed active transformer 700 with a low noise amplifier in accordance with another example. Although a low noise amplifier is shown, any suitable device can be used, including but not limited to a mixer, a transceiver, a filter, and a digital to analog converter.

In addition to the primary and secondary winding structures and associated push/pull amplifiers previously described, distributed active transformer 700 includes a split secondary winding 704 with switches 710A and 710B connected to low noise amplifier 712. Distributed active transformer 700 can be operated in a first transmit mode with switches 710A and 710B closed, as shown, and in a second receive mode with switches 710A and 710B open. When switches 710A and 710B are open, low noise amplifier 712 can be used to amplify a signal received at input 714. When switches 710A and 710B are closed, primary winding sections 702A through 702D of distributed active transformer 700 can be driven by push/pull amplifiers 706A and 708A through 706D and 708D, respectively, so that an input signal can be amplified and provided for transmission at input 714.

Although exemplary embodiments of the system and method of the present invention has been described in detail herein, those skilled in the art will also recognize that various substitutions and modifications can be made to the systems and methods without departing from the scope provided by the appended claims.

## Claims

1. A distributed active transformer comprising:
a primary winding including:
two or more pairs of push/pull amplifiers (106A and 108A, 106B and 108B, 106C and 108C, 106D and 108D);
two or more primary winding sections (102A, 102B, 102C,102D), each section having an associated pair of the two or more pairs of push/pull amplifiers and terminating at each end with an amplifier of its associated pair of push/pull amplifiers, each pair of push/pull amplifiers being configured to create an alternating current on the section of primary winding with which it is associated; and
one or more switches (110A, 110B, 110C,110D) connected to one push/pull amplifier from the pair associated with a primary winding section of the two or more sections and to one push/pull amplifier from the pair associated with another primary winding section of the two or more sections,
the one or more switches (110) being operable to bypass the push/pull amplifier from the pair associated with the primary winding section and the push-pull amplifier from the pair associated with the other primary winding section so as to combine the two sections into a single section; and
a secondary winding (104) disposed adjacent to the primary winding for inducing an alternating current in the secondary winding based on an alternating current in the primary winding,
the primary winding and the secondary winding (104) disposed on a semiconductor substrate.

2. The distributed active transformer of claim 1 wherein:
the two or more primary winding sections (102A, 102B, 102C, 102D) being a first section (102A), a second section (102B), a third section (102C), a fourth section (102D), and the one or more switches (110A, 110B, 110C, 110D) being a first switch (110A), a second switch (110B), a third switch (110C), and a fourth switch (110D);
the first switch (110A) connected to one of the push/pull amplifiers (106A) from the pair (106A and 108A) associated with the first section (102A) and to one of the push/pull amplifiers (108B) from the pair (106B and 108B) associated with the second section (102B), the first switch (110A) being operable to bypass the two push/pull amplifiers (106A, 108B) so connected;
the second switch (110B) connected to another of the push/pull amplifiers (106B) from the pair (106B and 108B) associated with the second section (102B) and to one of the push/pull amplifiers (108C) from the pair (106C and 108C) associated with the third section (102C), the second switch (110B) being operable to bypass the two push/pull amplifiers (106B, 108C) so connected;
the third switch (110C) connected to another of the push/pull amplifiers (106C) from the pair (106C and 108C) associated with the third section (102C) and to one of the push/pull amplifiers (108D) from the pair (106D, 108D) associated with the fourth section (102D), where the switch (110C) is operable to bypass the two push/pull amplifiers (106C, 108D) so connected;
the fourth switch (110D) connected to another of the push/pull amplifiers (106D) from the pair (106D, 108D) associated with the fourth section (102D) and to another of the push/pull amplifiers (108A) from the pair (106A, 108A) associated with the first section (102A), where the fourth switch (110D) is operable to bypass the two push/pull amplifiers (106D, 108A) so connected; and
the distributed active transformer (100) thereby is configured to operate in a high power mode when all four switches (110A, 110B, 110C, 110D) are open, in a medium high power mode when three switches are open, in a medium low power mode when two switches are open, and in a low power mode when a single switch is open.

3. The distributed active transformer of claim 1 wherein the one or more switches being a first switch (418A, 518A) connected to the primary winding section (402B, 502B); and further comprising: a second switch (414, 514) connected to the secondary winding (404, 504); a first capacitor (416A, 516A) connected to the first switch (418A, 518A); the primary winding section (402B, 502B) operable to be placed in resonance by closing the first switch (418A, 518A); a second capacitor (412, 512) connected to the second switch (414, 514); the secondary winding (504) operable to be placed in resonance by closing the second switch (514);
the distributed active transformer is configured to operate in a first power mode when the first switch (418A, 518A) is closed and the second switch (414, 514) is open, and in a second power mode when the first switch (418A, 518A) is open and the second switch (414, 514) is closed.

4. The distributed active transformer of claim 3 comprising a plurality of first switches (418A, 418B, 418C, 418D) and a corresponding plurality of first capacitors (416A, 416B, 416C, 416D), each connected to one of the first switches (418A, 418B, 418C, 418D) and one of the push/pull amplifiers of the two or more pairs of push/pull amplifiers (406A and 408A, 406B and 408B, 406C and 408C, 406D and 408D).

5. The distributed active transformer of claim 3 comprising a plurality of first switch pairs (518A, 518B, 518C, 518D) and a corresponding plurality of first capacitor pairs (516A, 516B, 516C, 516D), each connected to one of the first switches (518A, 518B, 518C, 518D) and where each capacitor of the first capacitor pairs (516A, 516B, 516C, 516D) is connected to one of the push/pull amplifiers (506A. 506B, 506C, 506D, 508A, 508B, 508C, 508D) in one of the two or more pairs of push/pull amplifiers (506A and 508A, 506B and 508B, 506C and 508C, 506D and 508D).

6. A method for providing a distributed active transformer on a semiconductor substrate using the distributed active transformer of claim 1, the method comprising:
causing current to flow in a first direction on the primary winding section of the two or more primary winding sections (102A, 102B, 102C, 102D) by controlling a first push/pull amplifier of the associated pair of the two or more pairs of push/pull amplifiers (106A and 108A, 106B and 108B, 106C and 108C, 106D and 108D) at a first point on the primary winding section and a second push/pull amplifier of the associated pair of the two or more pairs of push/pull amplifiers (106A and 108A, 106B and 108B, 106C and 108C, 106D and 108D) at a second point on the primary winding section, the first and second points on the primary winding section being the points at which the primary winding section terminates;
causing current to flow in a second direction on the primary winding section by controlling the first and second push/pull amplifiers of the associated pair of the two or more pairs of push/pull amplifiers (106A and 108A 106B and 108B, 106C and 108C, 106D and 108D); the current flowing in the first direction and the second direction in the primary winding section inducing an alternating current in a secondary winding; and
causing current to flow in the same direction on the other primary winding section of the two or more primary winding sections (102A, 102B, 102C, 102D) as the current on the primary winding section by controlling a third push/pull amplifier of the associated pair of the two or more pairs of push/pull amplifiers (106A and 108A, 106B and 108B, 106C and 108C, 106D and 108D) at a first point on the other primary winding section and a fourth push/pull amplifier of the associated pair of the two or more pairs of push/pull amplifiers (106A and 108A, 106B and 108B, 106C and 108C, 106D and 108D) at a second point on the other primary winding section, the first and second points on the other winding section being the points at which the other winding section terminates; and
causing current to flow over a portion of the primary winding section and the other primary winding section by controlling the one or more switches (110A, 110B, 110C, 110D) to bypass the second push/pull amplifier and the third push/pull amplifier so as to combine the two sections into a single section.

7. The method of claim 6 comprising providing a current source from a point between the first point and the second point.

## Patentansprüche

1. Verteilter aktiver Transformator, Folgendes umfassend:
eine Primärwicklung, die Folgendes beinhaltet:
zwei oder mehr Paare von Gegentaktverstärkern (106A und 108A, 106B und 108B, 106C und 108C, 106D und 108D);
zwei oder mehr Primärwicklungsabschnitte (102A, 102B, 102C,
102D), wobei jeder Abschnitt ein verknüpftes Paar von den zwei oder mehr Paaren von Gegentaktverstärkern aufweist und an jedem Ende mit einem Verstärker seines verknüpften Paares von Gegentaktverstärkern abschließt, wobei jedes Paar von Gegentaktverstärkern konfiguriert ist, um einen Wechselstrom auf dem Abschnitt der Primärwicklung, mit dem es verknüpft ist, zu erzeugen; und
einen oder mehrere Schalter (110A, 110B, 110C, 110D), verbunden mit einem Gegentaktverstärker von dem Paar, das mit einem Primärwicklungsabschnitt von den zwei oder mehr Abschnitten verknüpft ist, und mit einem Gegentaktverstärker von dem Paar, das mit einem anderen Primärwicklungsabschnitt der zwei oder mehr Abschnitten verknüpft ist,
wobei der eine oder die mehreren Schalter (110) betriebsfähig sind, um den Gegentaktverstärker von dem Paar, das mit dem Primärwicklungsabschnitt verknüpft ist, und den Gegentaktverstärker von dem Paar, das mit dem anderen Primärwicklungsabschnitt verknüpft ist, zu umgehen, sodass die zwei Abschnitte zu einem einzelnen Abschnitt kombiniert werden; und
eine Sekundärwicklung (104), die angrenzend an die Primärwicklung angeordnet ist, um einen Wechselstrom, basierend auf einem Wechselstrom in der Primärwicklung, in der Sekundärwicklung zu induzieren,
wobei die Primärwicklung und die Sekundärwicklung (104) auf einem Halbleitersubstrat angeordnet sind.

2. Verteilter aktiver Transformator nach Anspruch 1, wobei:
die zwei oder mehr Primärwicklungsabschnitte (102A, 102B, 102C, 102D) ein erster Abschnitt (102A), ein zweiter Abschnitt (102B), ein dritter Abschnitt (102C), ein vierter Abschnitt (102D) sind,
und der eine oder die mehreren Schalter (110A, 110B, 110C, 110D) ein erster Schalter (110A), ein zweiter Schalter (110B), ein dritter Schalter (110C) und ein vierter Schalter (110D) sind; wobei der erste Schalter (110A) mit einem der Gegentaktverstärker (106A) von dem mit dem ersten Abschnitt (102A) verknüpften Paar (106A und 108A) und mit einem der Gegentaktverstärker (108B) von dem mit dem zweiten Abschnitt (102B) verknüpften Paar (106B und 108B) verbunden ist,
wobei der erste Schalter (110A) betriebsfähig ist, um die zwei Gegentaktverstärker (106A, 108B), die derart verbunden sind, zu umgehen;
wobei der zweite Schalter (110B), der mit einem anderen der Gegentaktverstärker (106B) von dem mit dem zweiten Abschnitt (102B) verknüpften Paar (106B und 108B) und mit einem der Gegentaktverstärker (108C) von dem mit dem dritten Abschnitt (102C) verknüpften Paar (106C und 108C) verbunden ist, wobei der zweite Schalter (110B) betriebsfähig ist, um die zwei Gegentaktverstärker (106B, 108C), die derart verbunden sind, zu umgehen;
wobei der dritte Schalter (110C), der mit einem anderen der Gegentaktverstärker (106C) von dem mit dem dritten Abschnitt (102C) verknüpften Paar (106C und 108C) und mit einem der Gegentaktverstärker (108D) von dem mit dem vierten Abschnitt (102D) verknüpften Paar (106D und 108D) verbunden ist, wobei der Schalter (110C) betriebsfähig ist, um die zwei Gegentaktverstärker (106C, 108D), die derart verbunden sind, zu umgehen;
wobei der vierte Schalter (110D), der mit einem anderen der Gegentaktverstärker (106D) von dem mit dem vierten Abschnitt (102D) verknüpften Paar (106D, 108D) und mit einem anderen der Gegentaktverstärker (108A) von dem mit dem ersten Abschnitt (102A) verknüpften Paar (106A, 108A) verbunden ist, wobei der vierte Schalter (110D) betriebsfähig ist, um die zwei Gegentaktverstärker (106D, 108A), die derart verbunden sind, zu umgehen; und
wobei der verteilte aktive Transformator (100) dadurch konfiguriert ist, in einem Hochleistungsmodus zu arbeiten, wenn alle vier Schalter (110A, 110B, 110C, 110D) offen sind, in einem mittleren Hochleistungsmodus zu arbeiten, wenn drei Schalter offen sind, in einem mittleren Niederleistungsmodus zu arbeiten, wenn zwei Schalter offen sind, und in einem Niederleistungsmodus zu arbeiten, wenn ein einzelner Schalter offen ist.

3. Verteilter aktiver Transformator nach Anspruch 1, wobei der eine oder die mehreren Schalter die Folgenden sind:
ein erster Schalter (418A, 518A), verbunden mit dem Primärwicklungsabschnitt (402B, 502B);
und ferner Folgendes umfassend: einen zweiten Schalter (414, 514), der mit der Sekundärwicklung (404, 504) verbunden ist;
einen ersten Kondensator (416A, 516A), der mit dem ersten Schalter (418A, 518A) verbunden ist;
den Primärwicklungsabschnitt (402B, 502B), der betriebsfähig ist, um in Resonanz platziert zu werden, indem der erste Schalter (418A, 518A) geschlossen wird;
einen zweiten Kondensator (412, 512), der mit dem zweiten Schalter (414, 514) verbunden ist;
die Sekundärwicklung (504), die betriebsfähig ist, um in Resonanz platziert zu werden, indem der zweite Schalter (514) geschlossen wird;
wobei der verteilte aktive Transformator konfiguriert ist, um in einem ersten Leistungsmodus zu arbeiten, wenn der erste Schalter (418A, 518A) geschlossen ist und der zweite Schalter (414, 514) offen ist, und in einem zweiten Leistungsmodus zu arbeiten, wenn der erste Schalter (418A, 518A) offen ist und der zweite Schalter (414, 514) geschlossen ist.

4. Verteilter aktiver Transformator nach Anspruch 3, mehrere erste Schalter (418A, 418B, 418C, 418D) und mehrere entsprechende erste Kondensatoren (416A, 416B, 416C, 416D) umfassend, die jeweils mit einem der ersten Schalter (418A, 418B, 418C, 418D) und einem der Gegentaktverstärker der zwei oder mehr Paare von Gegentaktverstärkern (406A und 408A, 406B und 408B, 406C und 408C, 406D und 408D) verbunden sind.

5. Verteilter aktiver Transformator nach Anspruch 3, mehrere erste Schalterpaare (518A, 518B, 518C, 518D) und mehrere erste Kondensatorenpaare (516A, 516B, 516C, 516D) umfassend, die jeweils mit einem der ersten Schalter (518A, 518B, 518C, 518D) verbunden sind, und wobei jeder Kondensator der ersten Kondensatorpaare (516A, 516B, 516C, 516D) mit einem der Gegentaktverstärker (506A, 506B, 506C, 506D, 508A, 508B, 508C, 508D) in einem der zwei oder mehr Paare von Gegentaktverstärkern (506A und 508A, 506B und 508B, 506C und 508C, 506D und 508D) verbunden ist.

6. Verfahren zum Bereitstellen eines verteilten aktiven Transformators auf einem Halbleitersubstrat unter Verwendung des verteilten aktiven Transformators nach Anspruch 1, wobei das Verfahren Folgendes umfasst:
Bewirken, dass Strom in eine erste Richtung auf dem Primärwicklungsabschnitt von den zwei oder mehr Primärwicklungsabschnitten (102A, 102B, 102C, 102D) fließt, durch Steuern eines ersten Gegentaktverstärkers des verknüpften Paars von den zwei oder mehr Paaren von Gegentaktverstärkern (106A und 108A, 106B und 108B, 106C und 108C, 106D und 108D) an einem ersten Punkt auf dem Primärwicklungsabschnitt
und eines zweiten Gegentaktverstärkers des verknüpften Paars von den zwei oder mehr Paaren von Gegentaktverstärkern (106A und 108A, 106B und 108B, 106C und 108C, 106D und 108D) an einem zweiten Punkt auf dem Primärwicklungsabschnitt, wobei der erste und der zweite Punkt auf dem Primärwicklungsabschnitt die Punkte sind, an denen der Primärwicklungsabschnitt abschließt;
Bewirken, dass Strom in eine zweite Richtung auf dem Primärwicklungsabschnitt fließt, durch Steuern des ersten und des zweiten Gegentaktverstärkers des verknüpften Paars von den zwei oder mehr Paaren von Gegentaktverstärkern (106A und 108A, 106B und 108B, 106C und 108C, 106D und 108D);
wobei der Strom, der in die erste Richtung und die zweite Richtung in dem Primärwicklungsabschnitt fließt, einen Wechselstrom in einer Sekundärwicklung induziert; und
Bewirken, dass Strom in dieselbe Richtung auf dem anderen Primärwicklungsabschnitt der zwei oder mehr Primärwicklungsabschnitte (102A, 102B, 102C, 102D) wie der Strom auf dem Primärwicklungsabschnitt fließt, durch Steuern eines dritten Gegentaktverstärkers des verknüpften Paars der zwei oder mehr Paare von Gegentaktverstärkern (106A und 108A, 106B und 108B, 106C und 108C, 106D und 108D) an einem ersten Punkt auf dem anderen Primärwicklungsabschnitt und eines vierten Gegentaktverstärkers des verknüpften Paars von den zwei oder mehr Paaren von Gegentaktverstärkern (106A und 108A, 106B und 108B, 106C und 108C, 106D und 108D) an einem zweiten Punkt auf dem anderen Primärwicklungsabschnitt, wobei der erste und der zweite Punkt auf dem anderen Wicklungsabschnitt die Punkte sind, an denen der andere Wicklungsabschnitt abschließt; und
Bewirken, dass Strom über einen Teil des Primärwicklungsabschnitts und des anderen Primärwicklungsabschnitts fließt, indem der eine oder die mehreren Schalter (110A, 110B, 110C, 110D) gesteuert werden, um den zweiten Gegentaktverstärker und den dritten Gegentaktverstärker zu umgehen, sodass die zwei Abschnitte zu einem einzelnen Abschnitt kombiniert werden.

7. Verfahren nach Anspruch 6, das Bereitstellen einer Stromquelle von einem Punkt zwischen dem ersten Punkt und dem zweiten Punkt umfassend.

## Revendications

1. Transformateur actif distribué comprenant :
un enroulement primaire comprenant :
au moins deux paires d'amplificateurs symétriques (106A et 108A, 106B et 108B, 106C et 108C, 106D et 108D) ;
au moins deux sections d'enroulement primaire (102A, 102B, 102C, 102D), chaque section présentant une paire associée d'au moins deux paires d'amplificateurs symétriques et la terminaison, à chaque extrémité, par un amplificateur de sa paire associée d'amplificateurs symétriques, chaque paire d'amplificateurs symétriques étant conçue pour créer un courant alternatif sur la section d'enroulement primaire à laquelle il est associé ; et
au moins un interrupteur (110A, 110B, 110C, 110D) relié à un amplificateur symétrique provenant de la paire associée à une section d'enroulement primaire des au moins deux sections et à un amplificateur symétrique provenant de la paire associée à une autre région d'enroulement primaire des au moins deux sections,
l'au moins un interrupteur (110) pouvant servir à contourner l'amplificateur symétrique provenant de la paire associée à la section d'enroulement primaire et l'amplificateur symétrique provenant de la paire associée à l'autre section d'enroulement primaire, de façon à combiner les deux sections en une seule section unique ; et
un enroulement secondaire (104) disposé à côté de l'enroulement primaire destiné à l'induction d'un courant alternatif dans l'enroulement secondaire en fonction d'un courant alternatif dans l'enroulement primaire,
l'enroulement primaire et l'enroulement secondaire (104) étant disposés sur un substrat de semi-conducteur.

2. Transformateur actif distribué selon la revendication 1, dans lequel :
les au moins deux sections d'enroulement primaire (102A, 102B, 102C, 102D) étant une première section (102A), une deuxième section (102B), une troisième section (102C), une quatrième section (102D),
et l'au moins un interrupteur (110A, 110B, 110C, 110D) étant un premier interrupteur (110A), un deuxième interrupteur (110B), un troisième interrupteur (110C) et un quatrième interrupteur (110D) ;
le premier interrupteur (110A) étant relié à l'un des amplificateurs symétriques (106A) provenant de la paire (106A et 108A) associée à la première section (102A) et à l'un des amplificateurs symétriques (108B) provenant de la paire (106B et 108B) associée à la deuxième section (102B),
le premier interrupteur (110A) pouvant servir à contourner les deux amplificateurs symétriques (106A, 108B) ainsi reliés ;
le deuxième interrupteur (110B) étant relié à un autre des interrupteurs symétriques (106B) provenant de la paire (106B et 108B) associée à la deuxième section (102B) et à l'un des amplificateurs symétriques (108C) provenant de la paire (106C et 108C) associée à la troisième section (102C), le deuxième interrupteur (110B) pouvant servir à contourner les deux amplificateurs symétriques (106B, 108C) ainsi reliés ;
la troisième interrupteur (110C) étant relié à un autre des amplificateurs symétriques (106C) provenant de la paire (106C et 108C) associée à la troisième section (102C) et à l'un des amplificateurs symétriques (108D) provenant de la paire (106D, 108D) associée à la quatrième section (102D), l'interrupteur (110C) pouvant servir à contourner les deux amplificateurs symétriques (106C, 108D) ainsi reliés ;
le quatrième interrupteur (110D) étant relié à un autre des amplificateurs symétriques (106D) provenant de la paire (106D, 108D) associée à la quatrième section (102D) et à l'autre des amplificateurs symétriques (108A) provenant de la paire (106A, 108A) associée à la première section (102A), le quatrième interrupteur (110D) étant utilisé pour contourner les deux amplificateurs symétriques (106D, 108A) ainsi reliés ; et
le transformateur actif distribué (100) est ainsi conçu pour fonctionner selon un mode de puissance élevée lorsque les quatre interrupteurs (110A, 110B, 110C, 110D) sont tous ouverts, selon un mode de puissance moyennement élevée lorsque trois interrupteurs sont ouverts, selon un mode de puissance moyennement basse lorsque deux interrupteurs sont ouverts et selon un mode de puissance basse lorsqu'un seul interrupteur est ouvert.

3. Transformateur actif distribué selon la revendication 1, dans lequel l'au moins un interrupteur est un premier interrupteur (418A, 518A) relié à la section d'enroulement primaire (402B, 502B) ; et comprenant en outre : un deuxième interrupteur (414, 514) relié à l'enroulement secondaire (404, 504) ;
un premier condensateur (416A, 516A) relié au premier interrupteur (418A, 518A) ;
la section d'enroulement primaire (402B, 502B) pouvant servir à être placée en résonance par fermeture du premier interrupteur (418A, 518A) ;
un second condensateur (412, 512) étant relié au deuxième interrupteur (414, 514) ; l'enroulement secondaire (504) pouvant servir à être placé en résonance par fermeture du deuxième interrupteur (514) ;
le transformateur actif distribué est conçu pour fonctionner selon un premier mode de puissance lorsque le premier interrupteur (418A, 518A) est fermé et que le deuxième interrupteur (414, 514) est ouvert, et selon un second mode de puissance lorsque le premier interrupteur (418A, 518A) est ouvert et que le deuxième interrupteur (414, 514) est fermé.

4. Transformateur actif distribué selon la revendication 3, comprenant une pluralité de premiers interrupteurs (418A, 418B, 418C, 418D) et une pluralité correspondante de premiers condensateurs (416A, 416B, 416C, 416D), chacun étant relié à au moins l'un des premiers interrupteurs (418A, 418B, 418C, 418D) et à l'un des amplificateurs symétriques des au moins deux paires d'amplificateurs symétriques (406A et 408A, 406B et 408B, 406C et 408C, 406D et 408D).

5. Transformateur actif distribué selon la revendication 3, comprenant une pluralité de paires de premiers interrupteurs (518A, 518B, 518C, 518D) et une pluralité correspondante de paires de premiers condensateurs (516A, 516B, 516C, 516D), chacune étant reliée à l'au moins un des premiers interrupteurs (518A, 518B, 518C, 518D), et chaque condensateur des paires de premiers condensateurs (516A, 516B, 516C, 516D) étant relié à l'un des amplificateurs symétriques (506A, 506B, 506C, 506D, 508A, 508B, 508C, 508D) dans l'une des au moins deux paires d'amplificateurs symétriques (506A et 508A, 506B et 508B, 506C et 508C, 506D et 508D).

6. Procédé d'utilisation d'un transformateur actif distribué sur un substrat de semi-conducteur grâce au transformateur actif distribué selon la revendication 1, le procédé consistant à :
amener un courant à circuler dans un premier sens sur la section d'enroulement primaire des au moins deux sections d'enroulement primaire (102A, 102B, 102C, 102D) par la commande d'un premier amplificateur symétrique de la paire associée des au moins deux paires d'amplificateurs symétriques (106A et 108A, 106B et 108B, 106C et 108C, 106D et 108D) au niveau d'un premier point situé sur la section d'enroulement primaire et d'un deuxième amplificateur symétrique de la paire associée des au moins deux paires d'amplificateurs symétriques (106A et 108A, 106B et 108B, 106C et 108C, 106D et 108D) au niveau d'un second point situé sur la section d'enroulement primaire, les premier et second points situés sur la section d'enroulement primaire étant les points au niveau desquels se termine la section d'enroulement primaire ;
amener un courant à circuler dans un second sens sur la section d'enroulement primaire par la commande des premier et deuxième amplificateurs symétriques de la paire associée des au moins deux paires d'amplificateurs symétriques (106A et 108A, 106B et 108B, 106C et 108C, 106D et 108D) ;
le courant circulant dans le premier sens et dans le second sens dans la section d'enroulement primaire induisant un courant alternatif dans un enroulement secondaire ; et
amener un courant à circuler dans le même sens sur l'autre section d'enroulement primaire des au moins deux sections d'enroulement primaire (102A, 102B, 102C, 102D), en tant que courant sur la section d'enroulement primaire par la commande d'un troisième amplificateur symétrique de la paire associée à au moins deux paires d'amplificateurs symétriques (106A et 108A, 106B et 108B, 106C et 108C, 106D et 108D), au niveau d'un premier point situé sur l'autre section d'enroulement primaire et d'un quatrième amplificateur symétrique de la paire associée des au moins deux paires d'amplificateurs symétriques (106A et 108A, 106B et 108B, 106C et 108C, 106D et 108D), au niveau d'un second point situé sur l'autre section d'enroulement primaire, les premier et second points situés sur l'autre section d'enroulement étant les points au niveau desquels se termine l'autre section d'enroulement ; et
amener un courant à circuler sur une partie de la section d'enroulement primaire et sur l'autre partie d'enroulement primaire par la commande de l'au moins un interrupteur (110A, 110B, 110C, 110D) pour contourner le deuxième amplificateur symétrique et le troisième amplificateur symétrique de façon à combiner les deux sections en une section unique.

7. Procédé selon la revendication 6 comprenant l'obtention d'une source de courant à partir d'un point situé entre le premier point et le second point.
